# EUROPEAN PATENT SPECIFICATION

(11) **EP 1 708 513 B1**
(45) Date of publication and mention of the grant of the patent: **29.04.2015**
(21) Application number: 06111975.6
(22) Date of filing: 30.03.2006
(51) Int. Cl.: F21K 99/00, H01L 33/60, F21V 7/00, F21V 8/00, H04N 9/31, F21Y 101/02

(54) **Illumination unit and image projection apparatus employing the same**
Beleuchtungseinheit und Bildprojektionsapparat mit dieser Einheit
Unité d'éclairage et appareil de projection d'images utilisant une telle unité

(30) Priority: 30.03.2005 US 666181 P; 27.05.2005 KR 20050045200
(43) Date of publication of application: 04.10.2006
(73) Proprietor: Samsung Electronics Co., Ltd., Suwon-si, Gyeonggi-do, 443-742 (KR)
(72) Inventor: Kim, Jong-hoi, Gyeonggi-do (KR); Lee, Won-yong, Yeongtong-gu, Suwon-si Gyeonggi-do (KR); Lee, Young-chol, Gyeonggi-do (KR); Lee, Kye-hoon 848-203 Byeokjeokgol 9-danji, Suwon-si Gyeonggi-do (KR)
(74) Representative: Appleyard Lees

(56) References cited:
- EP-A1- 1 357 334
- EP-A1- 1 434 002
- EP-A1- 1 500 869
- US-A- 5 574 328
- US-A1- 2006 067 090
- US-A1- 2006 203 486
- US-A1- 2006 221 310

## Description

The present invention relates to an illumination unit capable of increasing the efficiency of collecting light emitted from a light source and an image projection apparatus employing the illumination unit.

In general, illumination units include a light source emitting light, and an illumination optical system transmitting light emitted from the light source. Illumination units are widely used for image projection apparatuses which create an image using an image-forming device such as a liquid crystal display (LCD) device or a digital light processing panel (DLP) comprised of a two dimensional array of micromirrors.

A metal halide lamp or a super-high voltage mercury lamp has been used as a light source of an illumination unit. Since the life span of these lamps is several thousands hours at most, the lamps need to be frequently replaced. To solve this problem, research on the use of a compact light-emitting device such as a light-emitting diode (LED) having a relatively longer life span has been conducted. Since an LED radiates light divergently, an illumination unit needs to collect and collimate the light emitted from the LED such that the light can propagate in one direction.

The LED emits relatively less light than the metal halide lamp or the super-high voltage mercury lamp. Accordingly, an array of LED modules must be used as a light source of image projection apparatuses.

To collimate light emitted from an LED, the LED modules generally comprise lenses. The array of LED modules using general lenses has low light efficiency as explained below.

The product of the emission area and the solid angle of the light emitted by the LED is a conserved value called the "etendue". Since the etendue is conserved, the product of the emission area and the solid angle of the light emitted by the LED should be equal to the product of the area of the image-forming device and the solid angle of incidence of the image-forming device. The etendue of the image-forming device is determined geometrically.

When an array of LED modules is used, the emission area of the array of LED modules is larger than the emission area of one LED module because the emission area increases in proportion to the number of LED modules.

Here, the solid angle of emission of each LED module is identical to the solid angle of emission of the array of LED modules, and the area of the image-forming device is fixed. According to etendue conservation, the solid angle of the incidence of the image-forming device is greater when the array of LED modules is used than when one LED module is used. Accordingly, some light exists outside the range of solid angle where light can be effectively projected by a projection lens and loss of light occurs, thereby reducing light efficiency. As a result, the luminance of the image-forming device is limited in spite of a greater number of LEDs.

DE-A1-10164033 mentions an optoelectronic component comprising a base housing having many light sources and a light exit window, with a diffuser in the base onto which rays are directed and from which diffuse light is reflected back through the window.

EP1,500,869 describes a lighting module such as for a motor vehicle headlight arranged to make a light beam with a directional limit or cutoff. The claims have been characterised against this document.

US 5574328 discloses a lighting module according to the preamble of claim 1.

According to the present invention there is provided an apparatus and method as set forth in the appended claims. Preferred features of the invention will be apparent from the dependent claims, and the description which follows.

The present invention provides an illumination unit capable of increasing the efficiency of collecting light emitted from a light source and an image projection apparatus employing the illumination unit.

According to an aspect of the present invention, there is provided an illumination unit comprising: a first reflective surface reflecting light incident thereon; a light-emitting device generating and emitting illuminating light; and a second reflective surface reflecting light emitted from the light-emitting device to a light source surface that includes the light-emitting device.

The first reflective surface may have a focal point, and the light-emitting device may be disposed at or around the focal point of the first reflective surface.

At least one of the first and second reflective surfaces may be selected from the group consisting of a parabolic reflective surface, a spherical reflective surface, and an elliptical reflective surface.

The first reflective surface may be a parabolic reflective surface and the second reflective surface may be a spherical reflective surface. A spherical center of the second reflective surface and the focal point of the first reflective surface may coincide.

The light-emitting device may be an organic light-emitting diode (OLED) or a light-emitting diode (LED).

The illumination unit may comprise a transparent light collector having a light incident surface, on which the second reflective surface is formed on a certain area of the light incident surface, and an outer side surface on which the first reflective surface is formed.

The light collector may include a light guide portion guiding light reflected by the first reflective surface.

The light incident surface of the light collector may be concave, and a predetermined optical medium or an air layer may exist between the light-emitting device and the light incident surface of the light collector.

The light incident surface of the light collector may have a concave dome shape.

The illumination unit may comprise a two-dimensional array of light collectors and a plurality of the light-emitting devices respectively corresponding to each of the light collectors.

According to another aspect of the present invention, there is provided an image projection apparatus comprising: at least one illumination unit; an image-forming device generating an image in response to an input image signal by using light emitted from the illumination unit; and a projection lens unit enlarging and projecting the image formed by the image-forming device, wherein the illumination unit comprises: a first reflective surface reflecting light incident thereon; a light-emitting device generating and emitting illuminating light; and a second reflective surface reflecting light emitted from the light-emitting device to a light source surface that includes the light-emitting device.

The at least one illumination unit may comprise a plurality of the illumination units emitting light of different colors, and the image projection apparatus may further comprise a color synthesis prism synthesizing the light of different colors emitted from the plurality of illumination units such that the synthesized light of different colors propagates along one optical path.

The image projection apparatus may further comprise a light integrator transforming the light of different colors emitted from the plurality of illumination units into uniform light.

The image-forming device may be selected from the group consisting of a transmissive liquid crystal display device, a reflective liquid crystal display device, and a reflective image-forming device comprising an array of micromirrors that selectively reflect the light emitted from the illumination units to form an image.

The illumination unit may comprise a transparent light collector that includes a concave dome-shaped light incident surface and a light guide portion guiding light reflected by the first reflective surface. The second reflective surface may be formed on a certain area of the light incident surface of the light collector on which light is incident from the light-emitting device, the first reflective surface may be formed on an outer side surface of the light collector, and a predetermined optical medium or an air layer may exist between the light-emitting device and the light incident surface of the light collector. The at least one illumination unit may comprise a plurality of illumination units emitting light of different colors. The image projection apparatus may further comprise: a color synthesis prism synthesizing the light of different colors emitted from the plurality of illumination units such that the synthesized light of different colors propagates along one optical path; and a light integrator transforming the light emitted from the plurality of illumination units into uniform light. The image-forming device may be selected from the group consisting of a transmissive liquid crystal display device, a reflective liquid crystal display device, and a reflective image-forming device comprising an array of micromirrors that selectively reflect the light emitted from the illumination units to form an image.

The above and other features and advantages of the present invention will become more apparent by describing in detail exemplary embodiments thereof with reference to the attached drawings in which:
Figure 1 is a perspective view of an example illumination unit as found in U.S. Patent Application No. 11/119,918;
Figure 2 is a cross-sectional view taken along line II-II of Figure 1;
Figure 3 is a conceptual view illustrating elements of an illumination unit according to an embodiment of the present invention;
Figure 4 is a perspective view of the illumination unit of Figure 3;
Figures 5 and 6 are cross-sectional views of illumination units according to other embodiments of the present invention;
Figure 7 is a perspective view of illumination units according to an embodiment of the present invention being formed as an array; and
Figures 8 through 10 are top views of image projection apparatuses employing the illumination unit according to embodiments of the present invention.

The present invention will now be described more fully with reference to the accompanying drawings, in which exemplary embodiments of the invention are shown.

An illumination unit according to the present invention has better light collecting efficiency than a conventional illumination unit. An example unit is disclosed in U.S. Patent Application No. 11/119,918, entitled "illumination unit using LED and an image projecting apparatus employing the same", owned by the applicant of the present invention.

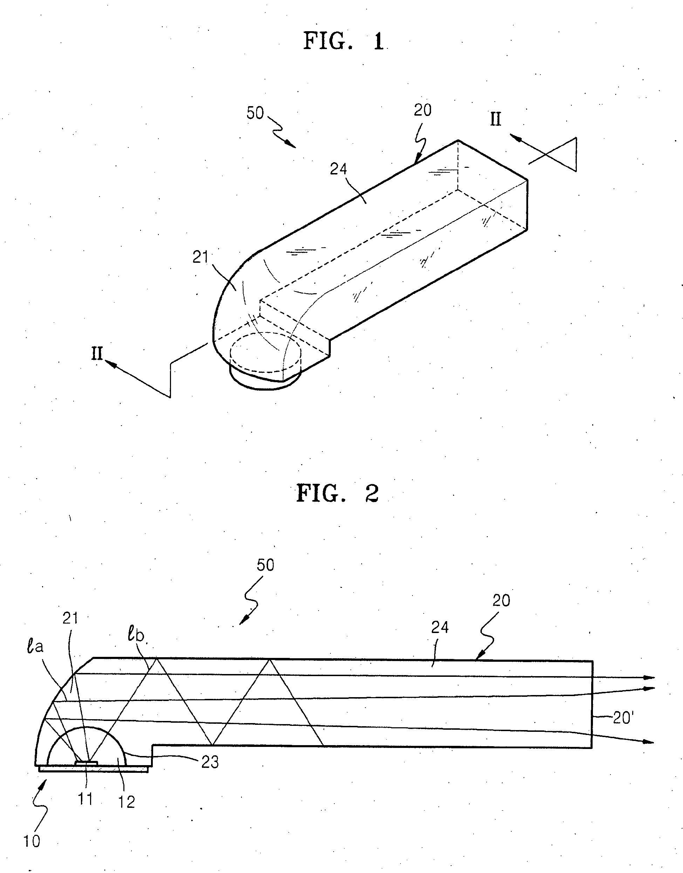

Figure 1 is a perspective view of an illumination unit 50 disclosed in U.S. Patent Application No. 11/119,918. Figure 2 is a cross-sectional view taken along line II-II of Figure 1.

Referring to Figures 1 and 2, the illumination unit 50 includes a light-emitting diode (LED) module 10 and a transparent rod 20. The rod 20 includes a parabolic reflective surface 21, and a light guide portion 24 guiding light reflected by the parabolic reflective surface 21. A recession 23 is formed in a surface of the rod 20 on which light is incident. The light guide portion 24 has a rectangular cross-section.

The LED module 10 includes an LED chip 11 emitting light. The LED module 10 may further include a dome lens or cap 12. The LED module 10 is disposed at a focal point of the parabolic reflective surface 21.

Light emitted from the LED chip 11 and incident on the parabolic reflective surface 21 is reflected by the parabolic reflective surface 21 to be collimated into substantially parallel light and then is guided by the light guide portion 24 to be emitted out of the illumination unit.

In the illumination unit 50, light ℓa incident on the parabolic reflective surface 21, among the light emitted from the LED chip 11, is collimated into substantially parallel light. The light ℓa is guided to a light exit surface 20' of the rod 20 along the light guide portion 24. Light ℓb emitted from the LED chip 11 and proceeding outside the region of the parabolic reflective surface 21 (right side of LED chip 11 in Figure 1) is not collimated into parallel light because it directly enters the light guide portion 24 without reflecting from the parabolic reflective surface 21. Accordingly, it is difficult to collect the light ℓb, thereby reducing light collecting efficiency.

However, an illumination unit according to the present invention can collimate light proceeding outside of the parabolic reflective surface 21 and propagating directly into the light guide portion so as to increase light collecting efficiency.

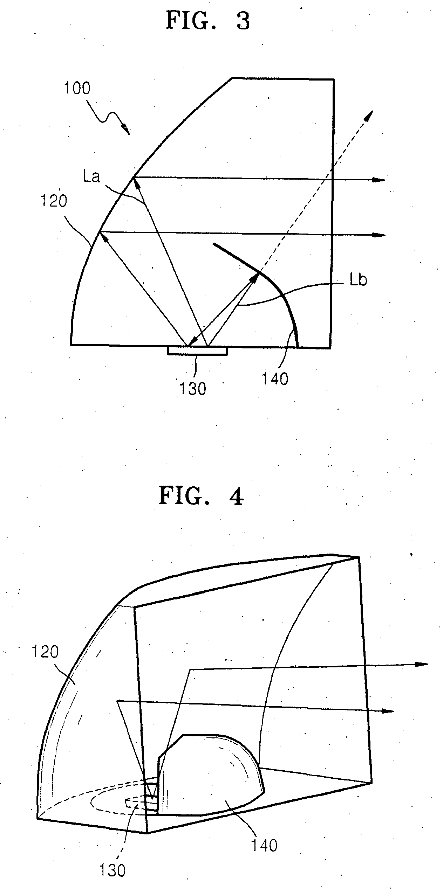

Figure 3 is a conceptual view illustrating elements of an illumination unit 100 according to an embodiment of the present invention. Figure 4 is a perspective view of the illumination unit 100 of Figure 3.

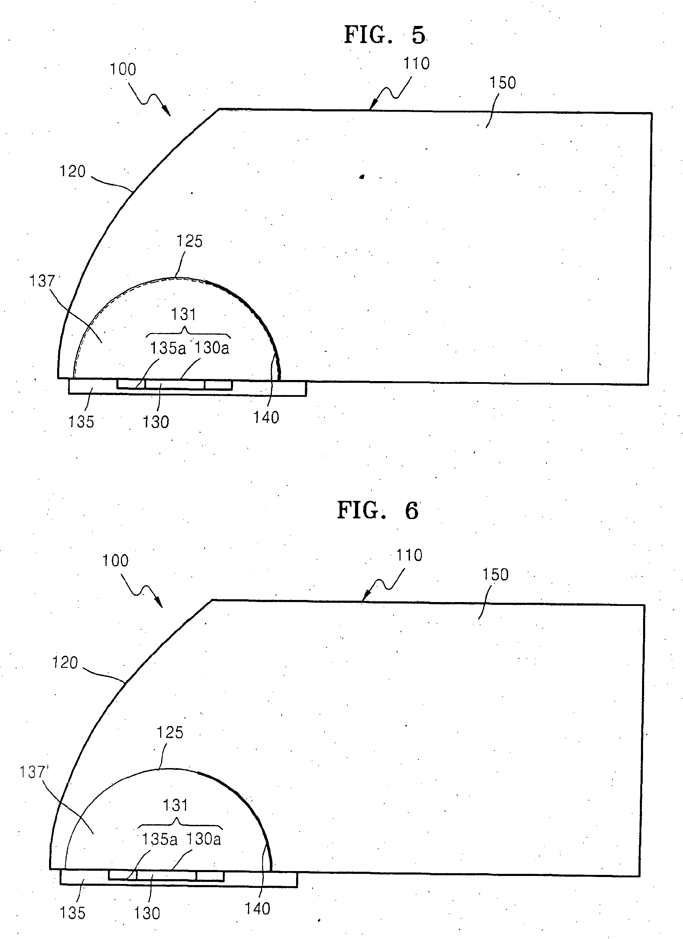

Referring to Figures 3 and 4, the illumination unit 100 includes a first reflective surface 120 reflecting light incident thereon, a light-emitting device 130 generating and emitting light, and a second reflective surface 140 reflecting light Lb. The light Lb is light emitted by the light-emitting device 130 and propagating outside the region of the first reflective surface 120. The light Lb is reflected by the second reflective surface to a light source surface (see 131 in Figures 5 and 6) that includes a light emission surface 130a of the light-emitting device 130.

The first reflective surface 120 is curved and has a focal point. The first reflective surface 120 may be selected from the group consisting of a parabolic reflective surface, a spherical reflective surface, and an elliptical reflective surface. The first reflective surface 120 reflects the light from the light-emitting device 130 and collimates the same into substantially parallel light.

The light-emitting device 130 may be disposed at or around the focal point of the first reflective surface 120. The light-emitting device 130 may include a light-emitting device chip, such as an LED or an organic light-emitting diode (OLED), which is also called an organic electroluminescent (EL) device.

The light-emitting device 130 may have reflective properties so that it may reflect external incident light. Since the light-emitting device chip such as the LED has a smooth surface, it has a predetermined reflectance. That is, the light-emitting device 130 may have the basic reflective properties of the light-emitting device chip.

The light-emitting device 130 may, in addition to such basic reflective properties, also include a reflective layer (not shown) to further increase reflectance of external light incident thereon. For example, the reflective layer may be formed between a substrate of the light-emitting device 130 and a semiconductor layer stacked on the substrate. In this case, the efficiency of reflecting light by means of the second reflective surface 140 to the light-emitting device 130, and reflecting light by means of the light-emitting device 130 to the first reflective surface 120, can be further increased.

Since the light-emitting device 130 is not a point light source but an area light source, some of the light reflected by the second reflective surface 140 may be incident outside the region of the light-emitting device 130. Accordingly, the light-emitting device 130 may be installed on a base 135 as shown in Figures 5 and 6, and in this case, the base 135 may have a reflective surface that reflects the light, which is reflected by the second reflective surface 140 and incident on the base 135, to the first reflective surface 120. Referring to Figures 5 and 6, the light source surface 131 may include the light emission surface 130a of the light-emitting device 130 or the sum region of the light emission surface 130a and the incident light reflecting region 135a of the base 135.

The second reflective surface 140 reflects the light Lb propagating outside the region of the first reflective surface 120 to the light source surface 131 that includes the light-emitting device 130 so that the light reflected by the light source surface 131 propagates toward the first reflective surface 120. A dotted line in Figure 3 represents a possible path of light proceeding outside the region of the first reflective surface 120 such that the output light lacks collimation as parallel light when the second reflective surface 140 is not present

The second reflective surface 140 may be selected from the group consisting of a parabolic reflective surface, a spherical reflective surface, and an elliptical reflective surface, like the first reflective surface 120.

A considerable amount of the light reflected by the second reflective surface 140 to be directed to the light-emitting device 130 and then, to the first reflective surface 120 is collimated into parallel light by the first reflective surface 120.

Accordingly, since the illumination unit 100 according to the present embodiment includes the second reflective surface 140 to reflect and feed the light Lb propagating in the region beyond the first reflective surface 120 back to the light-emitting device 130, the illumination unit 100 has higher light collecting efficiency than the illumination unit disclosed in U.S. Patent Application No. 11/119, 918.

The propagation of light with respect to the first and second reflective surfaces 120 and 140 according to various embodiments of the present invention will now be explained from the point of view of the collimation of light emitted from the illumination unit 100 into substantially parallel light rays.

For example, the first reflective surface 120 may be a parabolic reflective surface and the second reflective surface 140 may be a spherical reflective surface. The light-emitting device 130 may be disposed at or around a focal point of the first reflective surface 120, or at a spherical center of the second reflective surface 140. The focal point of the first reflective surface 120 and the spherical center of the second reflective surface 140 may be identical to each other, in which case the light-emitting device 130 may be disposed at the focal point of the first reflective surface 120 and at the spherical center of the second reflective surface 140.

In this case, light La emitted from the light-emitting device 130, which is disposed at the focal point of the first reflective surface 120, and propagating to the parabolic first reflective surface 120 is reflected and collimated by the first reflective surface 120 into substantially parallel light. The light Lb emitted from the light-emitting device 130 and propagating to the spherical second reflective surface 140 is reflected by the second reflective surface 140 and focused on the light-emitting device 130. The focused light is reflected by the light-emitting device 130 to propagate divergently to the first reflective surface 120 and then is collimated by the first reflective surface 120 into substantially parallel light to travel in the same direction as the light La that is emitted from the light-emitting device 130 and directly incident on the first reflective surface 120.

When the first reflective surface 120 is a parabolic reflective surface and the second reflective surface 140 is a spherical reflective surface, in this way, diverging light emitted from the light-emitting device 130 can be collimated into substantially parallel light to maximize the amount of light effectively emitted from the illumination unit 100.

Even when the first reflective surface 120 is a parabolic reflective surface and the light-emitting device 130 is disposed at the focal point of the first reflective surface 120, the light emitted from the light-emitting device 130 is collimated by the first reflective surface 120 into substantially parallel light, but not perfectly parallel light, because the light-emitting device 130 is not a point light source but an area light source. Since the light-emitting device 130 is an area light source, despite the spherical second reflective surface 140, not all the light reflected by the second reflective surface 140 is focused on one point of the light-emitting device 130. Still, a high percentage of the light is focused on the light-emitting device 130.

In the illumination unit 100, the light generated and emitted by the light-emitting device 130 is collimated into substantially parallel light. Here, the term "substantially parallel light" includes nearly parallel light having a divergent angle or a convergent angle within a range where the light can be collected by subsequent optical components.

Various embodiments are possible within the combination wherein each of the first reflective surface 120 and the second reflective surface 140 may be selected from one of a parabolic reflective surface, a spherical reflective surface, or an elliptical reflective surface.

For example, the first reflective surface 120 may be a spherical reflective surface to reflect divergent light emitted from the light-emitting device 130 disposed at or around a focal point of the first reflective surface 120 and collimate the reflected light into substantially parallel light.

The first reflective surface 120 may be an elliptical reflective surface to reflect divergent light emitted from the light-emitting device 130 disposed at or around a focal point of the first reflective surface 120 and collimate the reflected light into substantially parallel light.

As is well known, an ellipse has two focal points. Accordingly, divergent light emitted from the light-emitting device 130 disposed at one focal point incident on the elliptical reflective surface is reflected by the elliptical reflective surface to be focused on the other focal point of the elliptical reflective surface.

Accordingly, when the first reflective surface 120 is an elliptical reflective surface having two focal points distant from each other, light reflected by the first reflective surface 120 can be collimated into almost parallel light. Thus, when the first reflective surface 120 is an elliptical reflective surface close to a parabolic reflective surface, light reflected by the first reflective surface 120 can be collimated into substantially parallel light. Also, when the first reflective surface 120 is an elliptical reflective surface close to a spherical reflective surface, light reflected by the first reflective surface 120 can be collimated into substantially parallel light. The spherical reflective surface is an elliptical reflective surface whose two focal points coincide with each other.

Accordingly, even when the first reflective surface 120 is an elliptical reflective surface, light incident from the light-emitting device 130 can be collimated into substantially parallel light. The ratio of substantially parallel light which can be collected changes with the ellipticity of the first reflective surface 120.

The second reflective surface 140 may be a parabolic reflective surface, an elliptical reflective surface, or most preferably, a spherical reflective surface. Although the amount of light reflected by the parabolic or elliptical second reflective surface 140 to the light source surface 131 including the light-emitting device 130 and directed to and reflected by the first reflective surface 120 to be collimated into substantially parallel light is less than the amount of collimated substantially parallel light obtained through the usage of the spherical second reflective surface 140, the overall light collecting efficiency can be greatly increased with the use of the second reflective surface 140 compared to the case when the second reflective surface 140 is not used.

In describing the reflective surfaces 120 and 140, the term "parabolic surface" does not denote a parabolic surface strictly having a conic coefficient K of -1. The term "parabolic surface" used herein denotes an aspherical surface having a conic coefficient K between -0.4 and - 2.5, preferably, between -0.7 and -1.6. The conic coefficient K for the parabolic surface may be appropriately selected within the above range so as to collimate light emitted from the light-emitting device 130 within a range of radiation angles which result in effective illumination of an object.

The illumination unit 100 constructed as above permits the divergent light La emitted from the light-emitting device 130 and propagating to the first reflective surface 120 to be reflected and collimated by the first reflective surface 120. The reflected light is formed as parallel light according to the structure of the first reflective surface 120.

Since the light Lb emitted from the light-emitting device 130 and not propagating toward the first reflective surface 120 cannot be collimated in a conventional illumination unit, light collecting efficiency is deteriorated. To solve this problem, the illumination unit 100 of the present embodiment includes the second reflective surface 140 which reflects the light Lb to the light source surface 131 so that the light reflected by the light source surface 131 can be guided toward the first reflective surface 120, thereby being formed as parallel light by the first reflective surface 120.

The illumination unit 100 can increase light collecting efficiency by reflecting at least some of the light Lb, which is not produced as parallel light in a conventional illumination unit, by means of the second reflective surface 140 back to the light source surface 131.

Consequently, the illumination unit 100 according to the present embodiment can achieve higher light collecting efficiency than the illumination unit 100 disclosed in U.S. Patent Application No. 11/119,918 filed by the applicant of the present invention.

Figures 5 and 6 are cross-sectional views of illumination units 100 according to other embodiments.

Referring to Figures 5 and 6, the illumination unit 100 includes a transparent light collector 110 having a light incident surface 125 on which light is incident from the light-emitting device 130. The second reflective surface 140 may be formed on a certain area of the light incident surface 125 of the light collector 110, and the first reflective surface 120 may be formed on an outer side surface of the light collector 110.

The light incident surface 125 is concave. The light incident surface 125 may have a concave dome shape. In this case, the light-emitting device 130 can be disposed at a focal point of the first reflective surface 120, and the second reflective surface 140 can be formed with a dome shape on a certain area of the light incident surface 125. The light-emitting device 130 is installed on the base 135, and the base 135 is coupled to the light collector 110. The base 135 may have a reflective surface that can reflect light reflected by the second reflective surface 140 to the first reflective surface 120 as described above. The surface of the base 135 may be coated to reflect light.

In the illumination unit 100 according to the present embodiment, a predetermined optical medium 137 having a refractive index higher than air may be disposed between the light-emitting device 130 and the light incident surface 125 as shown in Figure 5. Alternatively, an air layer 137' may be filled between the light-emitting device 130 and the light incident surface 125 as shown in Figure 6.

The optical medium 137 may be a dome lens or cap of the light-emitting device 130. The optical medium 137 may be a medium additionally filled between the light-emitting device 130 and the light incident surface 125. When the light-emitting device 130 includes a dome lens or cap and the optical medium 137 exists, the refractive index of the optical medium 137 may be equal to the refractive index of the transparent light collector 110, or may be between the refractive index of the dome lens or cap and the refractive index of the transparent light collector 110.

In the illumination unit 100 of the present embodiment, the light collector 110 may further include a light guide portion 150 extending from the transparent body of the light collector 110. The light guide portion 150 guides light reflected by the first reflective surface 120 and collimated into parallel light. The light guide portion 150 may have a rectangular cross-section.

The light guide portion 150 may be formed to be stepped to decrease the area of the cross-section of the light guide portion 150 with respect to the portion of the light collector 110 where the light-emitting device 130 is coupled. That is, the light-emitting device 130 may protrude downward from the light collector 110 such that the light-emitting device 130 is lowered below the light guide portion 150. There exists the area which blocks light propagating to the light guide portion 150, i.e., the second reflective surface 140. Thus, to focus light at a center of a light exit surface of the light guide portion 152, not at an upper portion of the light exit surface of the light guide portion 152, the light guide portion 150 should be stepped.

The amount by which the light guide portion 150 is stepped with respect to the portion of the light collector 110 where the light-emitting device 130 is coupled can be appropriately determined within a range allowing light to be uniformly emitted from the entire light exit surface of the light guide portion 150 considering the size of the light blocking area of the second reflective surface 140.

When the light guide portion 150 is stepped above the portion of the light collector 110 where the light-emitting device 130 is coupled, modules of the light-emitting device 130 and the light collector 110 can be more easily arrayed, and a more uniform light distribution can be achieved on an exit surface of the array of the light collectors.

Since an LED emits less light than a conventional metal halide lamp or a super-high voltage mercury lamp, the light-emitting device 130 may include an array of LEDs.

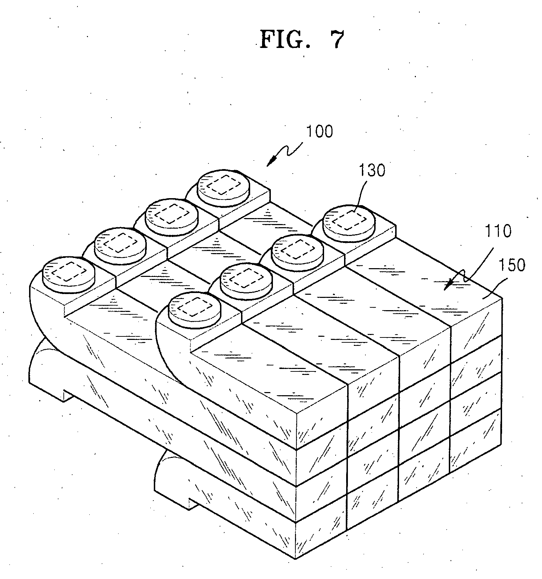

Thus, illumination unit 100 according to the present invention may be formed as an array, as shown in Figure 7. Figure 7 is a perspective view of illumination units 100 according to an embodiment of the present invention being formed as an array. Referring to Figure 7, the illumination unit 100 includes a two-dimensional array of modules of light-emitting devices 130 and light collectors 110 in which a plurality of light collectors 110 are arranged in two dimensions and a plurality of light-emitting devices 130 respectively correspond to the light collectors 110. The light-emitting device 130 and the base 135 configure a light-emitting module.

Since the illumination unit 100 can collimate most light emitted from the light-emitting device 130 into substantially parallel light by recycling at least some light emitted from the light-emitting device 130 which may be lost, by means of the second reflective surface 140, the illumination unit 100 can have high light collecting efficiency and can be used aS an illumination source for various systems. For example, the illumination unit 100 may be used as an illumination source for image projection apparatuses or as a headlight for vehicles.

An image projection apparatus using the illumination unit 100 as an illuminating light source according to various embodiments of the present invention will now be explained.

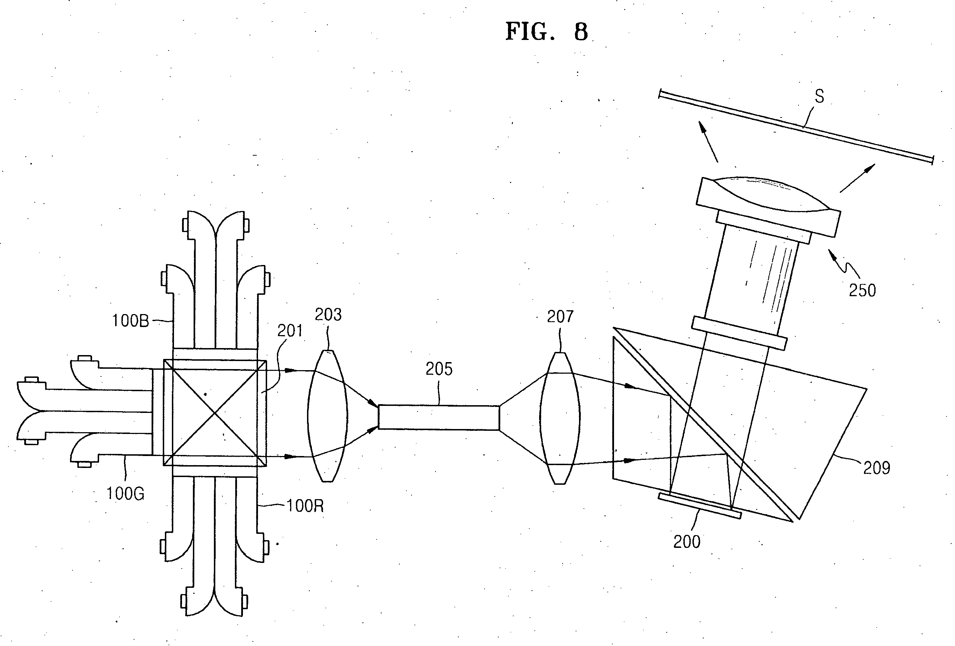

Figure 8 is a top view of an image projection apparatus employing the illumination unit 100 according to an embodiment of the present invention.

Referring to Figure 8, the image projection apparatus includes first through third illumination units 100R, 100G, and 100B, an image-forming device forming an image in response to an image signal using light incident from the first through third illumination units 100R, 100G, and 100B, and a projection lens unit 250 enlarging and projecting the image formed by the image-forming device onto a screen s.

The first through third illumination units 100R, 100G, and 100B may each be an illumination unit 100 of an array form as shown in Figure 7. That is, each of the first through third illumination units 100R, 100G, and 100B may include a two dimensional array of light collectors 110 and light-emitting devices 130 which correspond to each of the light collectors 110.

Since the light-emitting device such as an LED emits less light than a metal halide lamp or a super-high voltage mercury lamp, an array of light-emitting devices may be used.

The first through third illumination units 100R, 100G, and 100B may emit red light, green light, and blue light, respectively.

When the first through third illumination units 100R, 100G, and 100B emit different colors of light, a color synthesis prism 201, for example, an X-cube prism, may be further used to synthesize the different colors of light emitted from the first through third illumination units 100R, 100G, and 100B such that the synthesized colors of light can propagate along a single optical path. The image projection apparatus according to the present invention may include a single illumination unit emitting white light, and, in this case, the color synthesis prism 201 is not necessary.

The image projection apparatus according to the present invention may further include a light integrator that transforms incident light into uniform light. The light integrator integrates light incident along the same optical path after emission from the first through third illumination units 100R, 100G, and 100B and being synthesized such that the light is uniform.

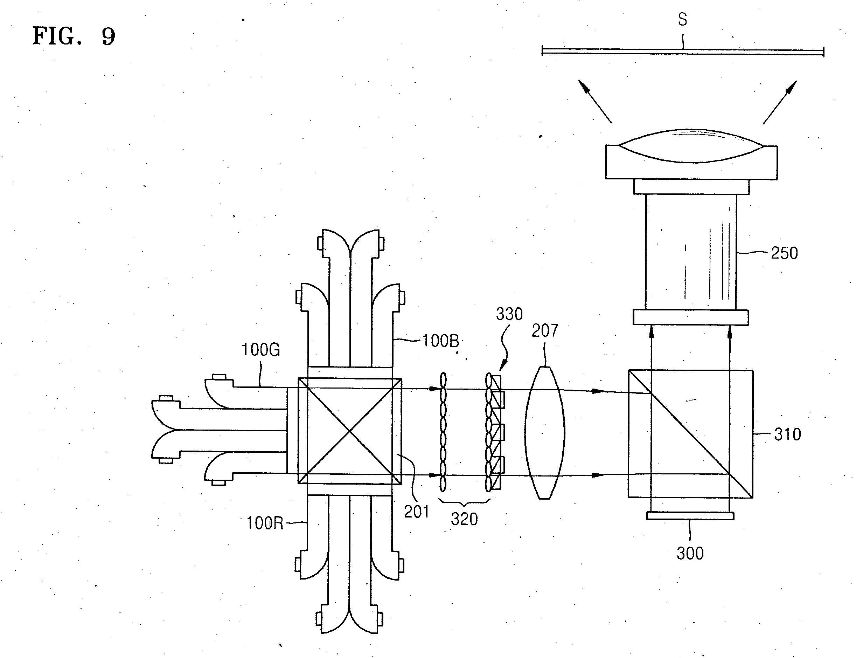

The light integrator may be a rectangular parallelepiped light tunnel 205 as shown in Figure 8. The rectangular parallelepiped light tunnel 205 may be hollow or an optical medium block. A pair of fly-eye lenses (see 320 in Figure 9) may be used as the light integrator, instead of the light tunnel 205.

The first through third illumination units 100R, 100G, and 100B have a light exit surface, and the light tunnel 205 has a light incident surface. The light exit surface of the first through third illumination units 100R, 100G, and 100B and the light incident surface of the light tunnel 205 may have similar forms. The light exit surface of the first through third illumination units 100R, 100G, and 100B and the light incident surface of the light tunnel 205 may have a rectangular shape having the same aspect ratio as the image forming device 200.

To this end, the light guide portions 150 of the light collectors 110 in each of the first through third illumination units 100R, 100G, and 100B are arranged in a two dimensional array to form a rectangular shape having the same aspect ratio as the light tunnel 205.

The image projection apparatus of the present invention may further include a condenser lens 203 along an optical path between the color synthesis prism 201 and the light tunnel 205 to condense light emitted from first through third light source units 10a, 10b, and 10c and synthesized by the color synthesis prism 201 to direct the light along a single optical path such that the condensed light having reduced beam size is incident on the light tunnel 205.

In the present embodiment, the image-forming device is a reflective image-forming device, which controls incident uniform light for each pixel to produce an image.

In Figure 8, the reflective image-forming device is a digital light processing (DLP) panel 200 or a digital micromirror device (DMD) with an array of micromirrors. The reflective image-forming device may be a reflective liquid crystal display (LCD). Alternatively, the image-forming device may be a transmissive LCD.

The DLP panel 200 includes a two-dimensional array of independently driven micromirrors, and creates an image by changing the angle of reflection light for each pixel based on an input image signal.

When the image-forming device is a reflective image-forming device, an optical path changer may be disposed between the light tunnel 205 and the reflective image-forming device to change the propagation path of incident light by directing light incident from the light tunnel 205 to the reflective image-forming device and light reflected by the reflective image-forming device to the projection lens unit 250. When the reflective image-forming device is the DLP panel 200, a total internal reflection (TIR) prism 70 may be used as the optical path changer as shown in Figure 8.

A relay lens 207 may be disposed between the light integrator and the optical path changer, that is, between the light tunnel 205 and the TIR prism 70, to scale up or down light emitted from the light integrator according to the effective area of the image-forming device.

In the image projection apparatus according to the present embodiment, light containing image information formed on the DLP panel 200 is transmitted through the TIR prism 70 and directed to the projection lens unit 250, and the projection lens unit 250 enlarges and projects the image formed on the DLP panel 200 onto the screen s.

Figure 9 is a top view of an image projection apparatus employing the illumination unit 100 according to another embodiment of the present invention. In the drawings, the same elements are designated by the same reference numerals, and a detailed explanation thereof will not be repeated.

Referring to Figure 9, the image projection apparatus according to another embodiment of the present invention includes a reflective LCD 300 as an image-forming device, unlike the image projection apparatus illustrated in Figure 8. The image projection apparatus according to the present embodiment may include a pair of fly-eye lenses 320 comprised of an array of a plurality of lens cells having the shape of a convex lens or cylindrical lens cells as the light integrator. Alternatively, the light tunnel 205 (see Figure 8) may be used as the light integrator, instead of the fly-eye lenses 320.

The reflective LCD 300 selectively reflects incident uniform illuminating light for each pixel to produce an image. The reflective LCD 300 forms an image by changing the polarization state of incident light for each pixel based on an image signal to turn on or off light to be reflected.

When the image-forming device is the reflective LCD 300, a polarization beam splitter 310 may be used as an optical path changer to change the propagation path of incident light. The polarization beam splitter 310 changes the propagation path of incident light by directing light with a polarization incident from the first through third illumination units 100R, 100G, and 100B to the reflective LCD 300 and light with another polarization reflected by the reflective LCD 300 to the projection lens unit 250.

To increase light efficiency, a polarization converting unit 330 may be disposed along an optical path between the fly-eye lenses 320 and the polarization beam splitter 310 so that light emitted from the first through third illumination units 100R, 100G, and 100B and incident on the polarization beam splitter 310 has a single polarization. The polarization converting unit 330 converts most non-polarized light incident thereon into light with a specific polarization by separating light according to polarizations using a plurality of small polarization beam splitters and disposing a half-wave plate only in an optical path of light with a predetermined polarization. The polarization converting unit is well known in the art.

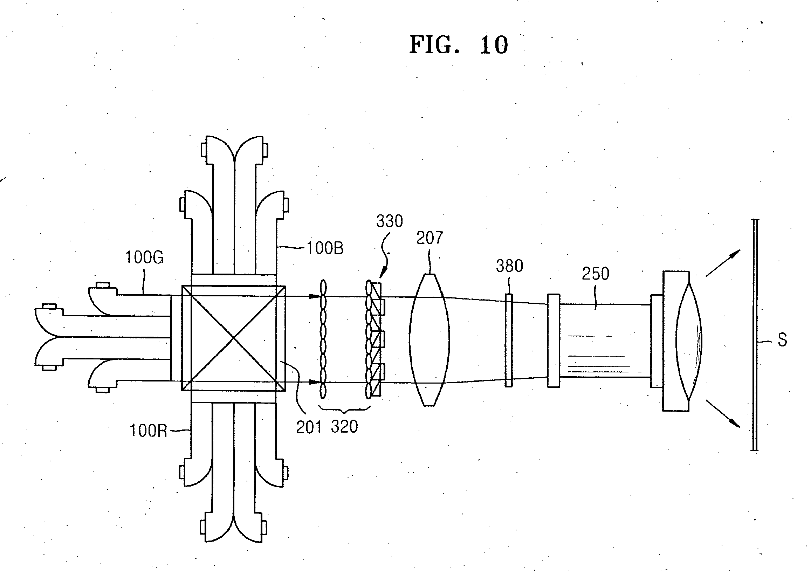

Figure 10 is a top view of an image projection apparatus employing the illumination unit 100 according to still another embodiment of the present invention.

Referring to Figure 10, the image projection apparatus according to still another embodiment of the present invention includes a transmissive LCD 380 as an image-forming device, unlike the image projection apparatus illustrated in Figure 9. When the transmissive LCD 380 is used as the image-forming device, the polarization beam splitter 310 (see Figure 9) functioning as the optical path changer is not necessary.

The transmissive LCD 380 forms an image by changing the polarization state of incident uniform light for each pixel based on an image signal to turn on or off light to be transmitted.

The illumination unit 100 can be applied to various image projection apparatuses as described above.

As described above, the illumination unit and the image projection apparatus employing the illumination unit can collimate most light emitted form the light-emitting device into substantially parallel light and thus ensure high light collecting efficiency without using lenses by using the second reflective surface that reflects light emitted from the light-emitting device and propagating outside the region of the first reflective surface back to the first reflective surface via the light-emitting device.

Although a few preferred embodiments have been shown and described, it will be appreciated by those skilled in the art that various changes and modifications might be made without departing from the scope of the invention, as defined in the appended claims.

## Claims

1. An illumination unit (100), comprising:
a light-emitting device (130) for generating and emitting illuminating light;
a light source surface (131) that is reflective and includes the light-emitting device (130); and
a first reflective surface (120) for reflecting light emitted by the light-emitting device; and
a second reflective surface (140) that reflects light emitted from the light-emitting device (130) toward the light source surface (131);
wherein the light reflected by the second reflective surface (140) is directed to the light-source surface (131) and then to the first reflective surface (120);
**characterised in that** the illumination unit further comprises a transparent light collector (110) having:
a light incident surface (125), wherein the second reflective surface (140) is formed on a certain area of the light incident surface (125); and
an outer side surface on which the first reflective surface (120) is formed.

2. The illumination unit (100) of claim 1, wherein the second reflective surface (140) reflects light traveling outside a region of the first reflective surface (120) back toward the light source surface (131).

3. The illumination unit (100) of claim 1 or 2, wherein the first reflective surface (120) has a focal point, and the light-emitting device (130) is disposed at or around the focal point of the first reflective surface (120).

4. The illumination unit (100) of claim 3, wherein at least one of the first and second reflective surfaces (120, 140) is selected from the group consisting of a parabolic reflective surface, a spherical reflective surface, and an elliptical reflective surface.

5. The illumination unit (100) of claim 3, wherein the first reflective surface (120) is a parabolic reflective surface and the second reflective surface (140) is a spherical reflective surface.

6. The illumination unit (100) of claim 5, wherein a spherical center of the second reflective surface (140) and the focal point of the first reflective surface (120) coincide.

7. The illumination unit (100) of any preceding claim, wherein the light-emitting device (130) is an organic light-emitting diode (OLED) or a light-emitting diode (LED) or arrays thereof.

8. The illumination unit (100) of any preceding claim, wherein the light collector (110) includes a light guide portion (150) for guiding light reflected by the first reflective surface (120).

9. The illumination unit (100) of any preceding claim, wherein the light incident surface (125) of the light collector (110) is concave, and a predetermined optical medium (137) or an air layer (137) is provided between the light-emitting device (130) and the light incident surface (125) of the light collector (110).

10. The illumination unit (100) of claim 9, wherein the light incident surface (125) of the light collector (110) has a concave dome shape.

11. The illumination unit (100) of any preceding claim, comprising a two-dimensional array of the light collectors (110) and a plurality of the light-emitting devices (130) respectively corresponding to each of the light collectors (110).

12. An image projection apparatus comprising:
at least one illumination unit (100) as set forth in any of claims 1 to 11;
an image-forming device (200) for generating an image in response to an input image signal using light emitted from the illumination unit (100); and
a projection lens unit (250) for enlarging and projecting the image formed by the image-forming device (200).

13. The image projection apparatus of claim 12, wherein the at least one illumination unit (100) comprises a plurality of the illumination units (100R, 100G, 100B) for emitting light of different colors, the image projection apparatus further comprising a color synthesis prism (201) for synthesizing the light of different colors emitted from the plurality of illumination units (100R, 100G, 100B) such that the synthesized light of different colors propagates along one optical path.

14. The image projection apparatus of claim 13, further comprising a light integrator (205) for transforming the light of different colors emitted from the plurality of illumination units (100R, 100G, 100B) into uniform light.

15. The image projection apparatus of claim 12, 13 or 14, wherein the image-forming device (200) is selected from the group consisting of a transmissive liquid crystal display device, a reflective liquid crystal display device, and a reflective image-forming device (200) comprising an array of micromirrors that selectively reflect the light emitted from the illumination units to form an image.

16. The image projection apparatus of claim 12, wherein the illumination unit (100) comprises a transparent light collector (110) that includes a concave dome-shaped light incident surface (125) and a light guide portion (150) guiding light reflected by the first reflective surface (120),
wherein the second reflective surface (140) is formed on a certain area of the light incident surface (125) of the light collector (110) on which light is incident from the light-emitting device (130), the first reflective surface (120) is formed on an outer side surface of the light collector (110), and a predetermined optical medium (137) or an air layer (137) exists between the light-emitting device (130) and the light incident surface (125) of the light collector (110),
wherein the at least one illumination unit (100) comprises a plurality of illumination units (100R, 100G, 100B) emitting light of different colors,
the image projection apparatus further comprising:
a color synthesis prism (201) synthesizing the light emitted from the plurality of illumination units (100R, 100G, 100B) such that the synthesized light of different colors propagates along one optical path; and
a light integrator (205) transforming the light emitted from the plurality of illumination units (100R, 100G, 100B) into uniform light,
wherein the image-forming device (200) is selected from the group consisting of a transmissive liquid crystal display device, a reflective liquid crystal display device, and a reflective image-forming device (200) comprising an array of micromirrors that selectively reflect the light emitted from the illumination units to form an image.

17. The image projection apparatus of claim 16, wherein each of the illumination units includes a two-dimensional array of the light collectors (110) and a plurality of the light-emitting devices (130) respectively corresponding to the light collectors (110).

## Patentansprüche

1. Beleuchtungseinheit (100), umfassend:
eine lichtemittierende Vorrichtung (130) zum Erzeugen und Emittieren von Beleuchtungslicht;
eine Lichtquellenoberfläche (131), die reflektierend ist und die lichtemittierende Vorrichtung (130) beinhaltet; und
eine erste reflektierende Oberfläche (120) zum Reflektieren von Licht, das von der lichtemittierenden Vorrichtung emittiert wird; und
eine zweite reflektierende Oberfläche (140), die Licht, das von der lichtemittierenden Vorrichtung (130) emittiert wird, zu der Lichtquellenoberfläche (131) reflektiert;
wobei das von der zweiten reflektierenden Oberfläche (140) reflektierte Licht auf die Lichtquellenoberfläche (131) und dann zur ersten reflektierenden Oberfläche (120) gerichtet ist;
**dadurch gekennzeichnet, dass** die Beleuchtungseinheit ferner einen transparentenen Lichtsammler (110) umfasst, mit:
einer Lichteinfallsoberfläche (125), wobei die zweite reflektierende Oberfläche (140) in einem bestimmten Gebiet der Lichteinfallsoberfläche (125) gebildet ist; und
einer äußeren Seitenoberfläche, auf der die erste reflektierende Oberfläche (120) gebildet ist.

2. Beleuchtungseinheit (100) nach Anspruch 1, wobei die zweite reflektierende Oberfläche (140) Licht reflektiert, das außerhalb eines Bereichs der ersten reflektierenden Oberfläche (120) zurück zu der Lichtquellenoberfläche (131) läuft.

3. Beleuchtungseinheit (100) nach Anspruch 1 oder 2, wobei die erste reflektierende Oberfläche (120) einen Brennpunkt aufweist und die lichtemittierende Vorrichtung (130) am oder um den Brennpunkt der ersten reflektierenden Oberfläche (120) herum angeordnet ist.

4. Beleuchtungseinheit (100) nach Anspruch 3, wobei die erste und/oder die zweite reflektierende Oberfläche (120, 140) aus der folgenden Gruppe ausgewählt ist: einer parabolischen reflektierenden Oberfläche, einer sphärischen reflektierenden Oberfläche und einer elliptischen reflektierenden Oberfläche.

5. Beleuchtungseinheit (100) nach Anspruch 3, wobei die erste reflektierende Oberfläche (120) eine parabolische reflektierende Oberfläche und die zweite reflektierende Oberfläche (140) eine sphärische reflektierende Oberfläche ist.

6. Beleuchtungseinheit (100) nach Anspruch 5, wobei ein sphärisches Zentrum der zweiten reflektierenden Oberfläche (140) und der Brennpunkt der ersten reflektierenden Oberfläche (120) übereinstimmen.

7. Beleuchtungseinheit (100) nach einem der vorhergehenden Ansprüche, wobei die lichtemittierende Vorrichtung (130) eine organische Leuchtdiode (OLED) oder eine Leuchtdiode (LED) oder Felder davon ist.

8. Beleuchtungseinheit (100) nach einem der vorhergehenden Ansprüche, wobei der Lichtsammler (110) einen Lichtleiterteil (150) zum Leiten von Licht, das von der ersten reflektierenden Oberfläche (120) reflektiert wurde, beinhaltet.

9. Beleuchtungseinheit (100) nach einem der vorhergehenden Ansprüche, wobei die Lichteinfallsoberfläche (125) des Lichtsammlers (110) konkav ist und ein vorbestimmtes optisches Medium (137) oder eine Luftschicht (137) zwischen der lichtemittierenden Vorrichtung (130) und der Lichteinfallsoberfläche (125) des Lichtsammlers (110) vorgesehen ist.

10. Beleuchtungseinheit (100) nach Anspruch 9, wobei die Lichteinfallsoberfläche (125) des Lichtsammlers (110) eine konkave Kuppelform aufweist.

11. Beleuchtungseinheit (100) nach einem der vorhergehenden Ansprüche, umfassend ein zweidimensionales Feld von Lichtsammlern (110) und mehreren lichtemittierenden Vorrichtungen (130), die jeweils jedem der Lichtsammler (110) entsprechen.

12. Bildprojektionsvorrichtung, die umfasst:
mindestens eine Beleuchtungseinheit (100) nach einem der Ansprüche 1 bis 11;
eine bildgebende Vorrichtung (200) zum Erzeugen eines Bilds als Reaktion auf ein Bildeingangssignal unter Verwendung von Licht, das von der Beleuchtungseinheit (100) emittiert wurde; und
eine Projektionslinseneinheit (250) zum Vergrößern und Projizieren des Bilds, das von der bildgebenden Vorrichtung (200) gebildet wurde.

13. Bildprojektionsvorrichtung nach Anspruch 12, wobei die mindestens eine Beleuchtungseinheit (100) mehrere der Beleuchtungseinheiten (100R, 100G, 100B) zum Emittieren von Licht verschiedener Farben umfasst, wobei die Bildprojektionsvorrichtung ferner ein Farbsyntheseprisma (201) zum Synthetisieren des Lichts verschiedener Farben umfasst, die von den mehreren Beleuchtungseinheiten (100R, 100G, 100B) emittiert werden, so dass sich das synthetisierte Licht verschiedener Farben entlang eines optischen Pfads fortbewegt.

14. Bildprojektionsvorrichtung nach Anspruch 13, ferner umfassend einen Lichtintegrator (205) zum Umwandeln des Lichts verschiedener Farben, das von den mehreren Beleuchtungseinheiten (100R, 100G, 100B) emittiert wird, in gleichmäßiges Licht.

15. Bildprojektionsvorrichtung nach Anspruch 12, 13 oder 14, wobei die bildgebende Vorrichtung (200) aus der folgenden Gruppe ausgewählt ist: einer transmittierenden Flüssigkristallanzeige-Vorrichtung, einer reflektierenden Flüssigkristallanzeige-Vorrichtung und einer reflektierenden bildgebenden Vorrichtung (200), die ein Feld von Mikrospiegeln umfasst, die selektiv das von den Beleuchtungseinheiten emittierte Licht reflektieren, um ein Bild zu formen.

16. Bildprojektionsvorrichtung nach Anspruch 12, wobei die Beleuchtungseinheit (100) einen transparenten Lichtsammler (110) umfasst, der eine konkave kuppelförmige Lichteinfallsoberfläche (125) und ein Lichtleiterteil (150) beinhaltet, das Licht, das von der ersten reflektierenden Oberfläche (120) reflektiert wird, leitet,
wobei die zweite reflektierende Oberfläche (140) in einem bestimmten Gebiet der Lichteinfallsoberfläche (125) des Lichtsammlers (110) gebildet ist, auf die Licht von der lichtemittierenden Vorrichtung (130) einfällt, die erste reflektierende Oberfläche (120) auf einer äußeren Seitenoberfläche des Lichtsammlers (110) gebildet ist und ein vorbestimmtes optisches Medium (137) oder eine Luftschicht (137) zwischen der lichtemittierenden Vorrichtung (130) und der Lichteinfallsoberfläche (125) des Lichtsammlers (110) existiert,
wobei die mindestens eine Beleuchtungseinheit (100) mehrere Beleuchtungseinheiten (100R, 100G, 100B) umfasst, die Licht verschiedener Farben emittieren,
wobei die Projektionsvorrichtung ferner umfasst:
ein Farbsyntheseprisma (201), das Licht, das von den mehreren Beleuchtungseinheiten (100R, 100G, 100B) emittiert wird, synthetisiert, so dass sich das synthetisierte Licht verschiedener Farben entlang eines optischen Pfads fortbewegt; und
einen Lichtintegrator (205), der Licht, das von den mehreren Beleuchtungseinheiten (100R, 100G, 100B) emittiert wird, in gleichmäßiges Licht umwandelt,
wobei die bildgebende Vorrichtung (200) aus der folgenden Gruppe ausgewählt ist: einer transmittierenden Flüssigkristallanzeige-Vorrichtung, einer reflektierenden Flüssigkristallanzeige-Vorrichtung und einer reflektierenden bildgebenden Vorrichtung (200), die ein Feld von Mikrospiegeln umfasst, die selektiv das von den Beleuchtungseinheiten emittierte Licht reflektieren, um ein Bild zu formen.

17. Bildprojektionsvorrichtung nach Anspruch 16, wobei jede der Beleuchtungseinheiten ein zweidimensionales Feld des Lichtsammler (110) und mehrere der lichtemittierenden Vorrichtungen (130), die den jeweiligen Lichtsammlern (110) entsprechen, beinhaltet.

## Revendications

1. Unité d'éclairage (100) comprenant :
un dispositif émetteur de lumière (130) pour générer et émettre une lumière d'éclairage ;
une surface source de lumière (131) qui est réfléchissante et qui comprend le dispositif émetteur de lumière (130) ; et
une première surface réfléchissante (120) pour réfléchir la lumière émise par le dispositif émetteur de lumière ; et
une seconde surface réfléchissante (140) pour réfléchir la lumière émise depuis le dispositif émetteur de lumière (130) vers la surface source de lumière (131) ;
où la lumière réfléchie par la seconde surface réfléchissante (140) est dirigée vers la surface source de lumière (131) puis vers la première surface réfléchissante (120) ;
**caractérisée en ce que** l'unité d'éclairage comprend en outre un collecteur de lumière transparent (110) ayant :
une surface d'incidence de lumière (125), où la seconde surface réfléchissante (140) est formée sur une certaine zone de la surface d'incidence de lumière (125) ; et
une surface latérale externe sur laquelle la première surface réfléchissante (120) est formée.

2. Unité d'éclairage (100) selon la revendication 1, dans laquelle la seconde surface réfléchissante (140) réfléchit la lumière se déplaçant à l'extérieur d'une région de la première surface réfléchissante (120) et la renvoie vers la surface source de lumière (131).

3. Unité d'éclairage (100) selon la revendication 1 ou la revendication 2, dans laquelle la première surface réfléchissante (120) a un point focal, et le dispositif émetteur de lumière (130) est disposé au niveau ou autour du point focal de la première surface réfléchissante (120).

4. Unité d'éclairage (100) selon la revendication 3, dans laquelle au moins l'une des première et seconde surfaces réfléchissantes (120, 140) est sélectionnée dans le groupe constitué d'une surface réfléchissante parabolique, d'une surface réfléchissante sphérique et d'une surface réfléchissante elliptique.

5. Unité d'éclairage (100) selon la revendication 3, dans laquelle la première surface réfléchissante (120) est une surface réfléchissante parabolique et la seconde surface réfléchissante (140) est une surface réfléchissante sphérique.

6. Unité d'éclairage (100) selon la revendication 5, dans laquelle un centre sphérique de la seconde surface réfléchissante (140) et le point focal de la première surface réfléchissante (120) coïncident.

7. Unité d'éclairage (100) selon l'une quelconque des revendications précédentes, dans laquelle le dispositif émetteur de lumière (130) est une diode électroluminescente organique (OLED) ou une diode électroluminescente (LED) ou des réseaux de celles-ci.

8. Unité d'éclairage (100) selon l'une quelconque des revendications précédentes, dans laquelle le collecteur de lumière (110) comprend une portion de guide de lumière (150) pour guider la lumière réfléchie par la première surface réfléchissante (120).

9. Unité d'éclairage (100) selon l'une quelconque des revendications précédentes, dans laquelle la surface d'incidence de lumière (125) du collecteur de lumière (110) est concave, et un milieu optique prédéterminé (137) ou une couche d'air (137) sont pourvus entre le dispositif émetteur de lumière (130) et la surface d'incidence de lumière (125) du collecteur de lumière (110).

10. Unité d'éclairage (100) selon la revendication 9, dans laquelle la surface d'incidence de lumière (125) du collecteur de lumière (110) a une forme de dôme concave.

11. Unité d'éclairage (100) selon l'une quelconque des revendications précédentes, comprenant un réseau bidimensionnel de collecteurs de lumière (110) et une pluralité de dispositifs émetteurs de lumière (130) correspondant respectivement à chacun des collecteurs de lumière (110).

12. Appareil de projection d'image comprenant :
au moins une unité d'éclairage (100) telle que décrite dans l'une quelconque des revendications 1 à 11 ;
un dispositif de formation d'image (200) pour générer une image en réponse à un signal d'image d'entrée utilisant une lumière émise depuis l'unité d'éclairage (100) ; et
une unité d'objectif de projection (250) pour agrandir et projeter l'image formée par le dispositif de formation d'image (200).

13. Appareil de projection d'image selon la revendication 12, dans lequel l'au moins une unité d'éclairage (100) comprend une pluralité d'unités d'éclairage (100R, 100G, 100B) pour émettre une lumière de différentes couleurs, l'appareil de projection d'image comprenant en outre un prisme de synthèse des couleurs (201) pour synthétiser la lumière de différentes couleurs émise par la pluralité d'unités d'éclairage (100R, 100G, 100B) de manière à ce que la lumière synthétisée de différentes couleurs se propage le long d'un chemin optique.

14. Appareil de projection d'image selon la revendication 13, comprenant en outre un intégrateur de lumière (205) pour transformer la lumière de différentes couleurs émise par la pluralité d'unités d'éclairage (100R, 100G, 100B) en une lumière uniforme.

15. Appareil de projection d'image selon les revendications 12, 13 ou 14, dans lequel le dispositif de formation d'image (200) est sélectionné dans le groupe constitué d'un dispositif d'affichage à cristaux liquides transmissif, d'un dispositif d'affichage à cristaux liquides réflexif, et d'un dispositif de formation d'image réfléchissant (200) comprenant une matrice de micro-miroirs qui reflètent de manière sélective la lumière émise par les unités d'éclairage pour former une image.

16. Appareil de projection d'image selon la revendication 12, dans lequel l'unité d'éclairage (100) comprend un collecteur de lumière transparent (110) qui comprend une surface d'incidence de lumière en forme de dôme concave (125) et une portion de guide de lumière (150) guidant la lumière réfléchie par la première surface réfléchissante (120),
où la seconde surface réfléchissante (140) est formée sur une certaine zone de la surface d'incidence de lumière (125) du collecteur de lumière (110) sur lequel la lumière est incidente à partir du dispositif émetteur de lumière (130), la première surface réfléchissante (120) est formée sur une surface latérale extérieure du collecteur de lumière (110), et un milieu optique prédéterminé (137) ou une couche d'air (137) existent entre le dispositif émetteur de lumière (130) et la surface d'incidence de lumière (125) du collecteur de lumière (110),
où l'au moins une unité d'éclairage (100) comprend une pluralité d'unités d'éclairage (100R, 100G, 100B) émettant de la lumière de différentes couleurs,
l'appareil de projection d'image comprenant en outre :
un prisme de synthèse des couleurs (201) synthétisant la lumière émise par la pluralité d'unités d'éclairage (100R, 100G, 100B) de sorte que la lumière synthétisée de différentes couleurs se propage le long d'un chemin optique ; et
un intégrateur de lumière (205) transformant la lumière émise par la pluralité d'unités d'éclairage (100R, 100G, 100B) en lumière uniforme,
où le dispositif de formation d'image (200) est sélectionné dans le groupe constitué d'un dispositif d'affichage à cristaux liquides transmissif, d'un dispositif d'affichage à cristaux liquides réflexif, et un dispositif de formation d'image réfléchissant (200) comprenant une matrice de micro-miroirs qui reflètent de manière sélective la lumière émise par les unités d'éclairage pour former une image.

17. Appareil de projection d'image selon la revendication 16, dans lequel chacune des unités d'éclairage comprend un réseau bidimensionnel de collecteurs de lumière (110) et une pluralité de dispositifs émetteurs de lumière (130) correspondant respectivement aux collecteurs de lumière (110).
